# DEMANDE DE BREVET EUROPEEN

(11) **EP 4 087 134 A1**
(43) Date de publication de la demande: **09.11.2022**
(21) Numéro de dépôt: 22171370.4
(22) Date de dépôt: 03.05.2022
(51) Int. Cl.: H03K 17/08, H03K 17/18

(54) **DISPOSITIF DE CONTRÔLE D'UN TRANSISTOR ET PROCÉDÉ DE CONTRÔLE ASSOCIÉ**

(30) Priorité: 04.05.2021 FR 2104676
(71) Demandeur: SpeedInnov, 75008 Paris (FR)
(72) Inventeur: RABASSE, Eric, 65310 HORGUES (FR); BOULIN, Mathieu, 65000 TARBES (FR)
(74) Mandataire: Lavoix

(57) **Abrégé**

Le dispositif (14) de contrôle d'un transistor (12) comprend :
- un module de supervision (20) apte à générer un signal de commande (SC) ;
- un allumeur (22) apte à contrôler le fonctionnement du transistor (12) à partir du signal de commande (SC), à détecter un dysfonctionnement du transistor (12) et à générer un signal d'alerte en cas de détection d'un dysfonctionnement du transistor (12) ;
- un module de gestion (24) apte à recevoir le signal d'alerte ;
l'allumeur (22) étant apte, en cas de détection d'un dysfonctionnement du transistor (12), à générer des données de défaut représentatives dudit dysfonctionnement et à encoder lesdites données de défaut dans le signal d'alerte en formant une composante utile du signal d'alerte, le module de gestion (24) étant apte à extraire les données de défaut en décodant la composante utile.

## Description

La présente invention concerne un dispositif de contrôle d'un transistor.

La présente invention concerne également un procédé de contrôle associé à un tel dispositif de contrôle.

L'invention s'applique au domaine du transport, notamment aux véhicules de transport tel que les véhicules ferroviaires ou les véhicules de transport routier.

Un tel dispositif de contrôle permet, par exemple, de contrôler le fonctionnement d'un transistor, par exemple, un transistor de puissance au sein d'un système de commutation intégré à un tel véhicule.

Il est connu de l'état de la technique qu'un tel dispositif de contrôle comprenne un allumeur propre à contrôler le transistor et un module de supervision propre à commander l'allumeur. Pour contrôler le transistor, l'allumeur transmet par exemple un courant de contrôle à une électrode de grille du transistor.

Toutefois, il peut arriver qu'un dysfonctionnement se produise au sein du transistor, au sein de l'allumeur ou en dehors de l'ensemble comprenant le transistor et l'allumeur. La commande du transistor par le module de supervision est alors perturbée. En outre, en cas de dysfonctionnement, le maintien d'un courant de contrôle à l'électrode de grille du transistor peut entraîner d'autres avaries importantes du dispositif de contrôle ou du transistor, voire une destruction du transistor lui-même ou de l'ensemble.

L'un des buts de l'invention est de pallier cet inconvénient en proposant un dispositif de contrôle dont la sûreté et la sécurité est améliorée.

A cet effet, l'invention concerne un dispositif de contrôle d'un transistor comprenant :
- un module de supervision apte à générer un signal de commande ;
- un allumeur apte à contrôler le fonctionnement du transistor à partir du signal de commande, à détecter un dysfonctionnement du transistor et à générer un signal d'alerte en cas de détection d'un dysfonctionnement du transistor ;
- un module de gestion apte à recevoir le signal d'alerte ;
   l'allumeur étant apte en outre, en cas de détection d'un dysfonctionnement du transistor, à générer des données de défaut représentatives dudit dysfonctionnement et à encoder lesdites données de défaut dans le signal d'alerte en formant une composante utile du signal d'alerte correspondant, le module de gestion étant apte à extraire les données de défaut en décodant la composante utile du signal d'alerte.

Grâce à l'invention, en plus d'être informé de la présence d'un dysfonctionnement du transistor, le module de gestion reçoit des informations supplémentaires sur le dysfonctionnement. En outre, lesdites données de défaut sont directement encodées dans le signal d'alerte ce qui revient à transmettre ces informations supplémentaires de manière efficace. De plus, un seul signal contenant toutes les informations nécessaires est transmis depuis l'allumeur vers le module de gestion.

Selon d'autres caractéristiques de l'invention, prises isolément ou selon toute combinaison techniquement envisageable :
- les données de défaut comprennent au moins la nature du dysfonctionnement choisi dans la liste comprenant un non-allumage du transistor, une non-saturation du transistor, une désaturation du transistor, une sous-tension du transistor et une surtension du transistor ;
- les données de défaut sont encodées selon le protocole RS-232 ;
- le signal de commande et le signal d'alerte sont des signaux sensiblement logiques étant soit à un niveau haut soit à un niveau bas opposé au niveau haut ;
- lorsqu'aucun dysfonctionnement du transistor n'est détecté, l'allumeur est apte à générer un signal nominal, le signal nominal étant un signal logique opposé du signal de commande, le module de gestion étant apte, en outre, à recevoir le signal nominal ;
- le signal d'alerte est un signal constant sur au moins une période de temps à partir d'un instant de détection du dysfonctionnement, le signal d'alerte étant au même niveau que le niveau du signal de commande à l'instant de détection du dysfonctionnement ;
- l'allumeur est configuré pour encoder les données de défaut dans le signal d'alerte après ladite période de temps ;
- le module de gestion est configuré pour générer un message d'alerte à destination du module de supervision en cas de réception du signal d'alerte ; et
- le module de gestion est configuré en outre pour empêcher l'allumeur de contrôler le transistor en cas de réception du signal d'alerte.

L'invention concerne, en outre, un procédé de contrôle d'un transistor, comprenant les étapes de :
- génération d'un signal de commande par un module de supervision ;
- contrôle du fonctionnement du transistor à partir du signal de commande ;
- génération d'un signal d'alerte en cas de détection d'un dysfonctionnement du transistor ;
- génération de données de défaut représentatives dudit dysfonctionnement et encodage desdites données de défaut dans le signal d'alerte en formant une composante utile du signal d'alerte correspondant ; et
- réception du signal d'alerte par un module de gestion et extraction des données de défaut par décodage de la composante utile du signal d'alerte.

D'autres aspects et avantages de l'invention apparaîtront à la lecture de la description qui suit, donnée à titre d'exemple et faite en référence aux dessins annexes, dans lesquels :
[Fig 1] la figure 1 est une représentation schématique illustrant un transistor et un dispositif de contrôle du transistor selon l'invention ; et
[Fig 2] la figure 2 illustre un chronogramme d'un signal de commande et un chronogramme d'un signal généré par l'allumeur du dispositif de contrôle illustré sur la figure 1, le signal généré par l'allumeur comprenant une portion correspondant à un signal nominal et une portion correspondant à un signal d'alerte.

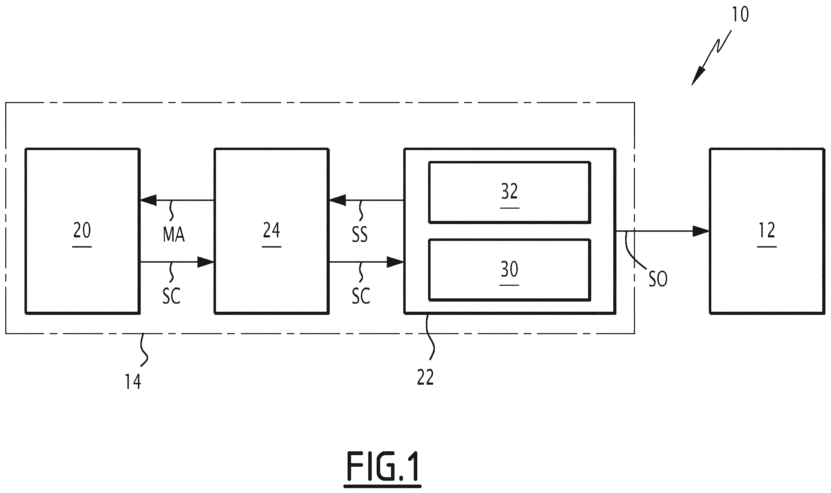

En référence à la figure 1, on décrit un système électronique 10 comprenant un transistor 12 et un dispositif 14 de contrôle du transistor 12.

Le système électronique 10 est, par exemple, intégré sur un véhicule de transport.

Le véhicule de transport est, par exemple, un véhicule ferroviaire tel qu'un train ou un véhicule automobile tel qu'un bus.

Le transistor 12 est configuré pour être contrôlé par le dispositif 14 entre un état passant, dans lequel le transistor 12 transmet un courant à un élément électronique externe et un état bloqué dans lequel aucun courant n'est transmis via le transistor 12 à l'élément électronique externe.

Le transistor 12 est, par exemple, un transistor de puissance tel qu'un transistor bipolaire à grille isolée (en anglais « *Insulated Gate Bipolar Transistor* » ou IGBT). En variante, le transistor 12 est un transistor à effet de champ à grille isolée (en anglais « *Metal Oxide Semiconductor Field Effect Transistor* » ou MOSFET) par exemple un transistor à base de carbure de silicium.

Le transistor 12 comprend, par exemple, une électrode de grille par l'intermédiaire de laquelle le dispositif de contrôle 14 contrôle le transistor 12.

Le dispositif de contrôle 14 comprend un module 20 de supervision, un allumeur 22 du transistor 12 et un module 24 de gestion de l'allumeur 22.

Le module de supervision 20 est connecté au module de gestion 24. Il est apte à générer au moins un signal de commande SC et à le transmettre au module de gestion 24.

L'allumeur 22 est connecté au transistor 12 et au module de gestion 24. Il est configuré pour recevoir le signal de commande SC depuis le module de gestion 24.

L'allumeur 22 est apte à contrôler le fonctionnement du transistor 12 à partir du signal de commande SC. En particulier, l'allumeur 22 est apte à contrôler le transistor 12 entre l'état passant et l'état bloqué en générant un signal de contrôle SO dépendant du signal de commande SC et en transmettant le signal de contrôle SO au transistor 12. En particulier, pour ce faire, l'allumeur 22 est connecté à l'électrode de grille du transistor 12. L'allumeur 22 transmet un courant de contrôle par l'intermédiaire du signal de contrôle SO à l'électrode de grille du transistor 12. L'état passant ou bloqué dépend du courant de contrôle transmis par l'allumeur 22.

L'allumeur 22 est, en outre, configuré pour générer un signal de supervision SS et le transmettre au module de gestion 24. Le signal de supervision SS est un signal dépendant du signal de commande SC.

L'allumeur 22 est, en outre, apte à détecter un dysfonctionnement du transistor 12, à générer un signal d'alerte SA en cas de détection d'un dysfonctionnement du transistor 12 et à intégrer le signal d'alerte SA dans le signal de supervision SS. Le signal de supervision SS correspond alors au signal d'alerte SA.

Un tel dysfonctionnement est, par exemple, un non-allumage du transistor 12, une non-saturation du transistor 12, une désaturation du transistor 12, une sous-tension du transistor 12, une surtension du transistor 12. Ledit dysfonctionnement survient par exemple suite à la transmission du signal de contrôle SO au transistor 12.

En particulier, l'allumeur 22 comprend une unité de contrôle 30 apte à contrôler le fonctionnement du transistor 12 et une unité de surveillance 32 apte à détecter un dysfonctionnement du transistor 12 et à générer le signal d'alerte SA le cas échéant.

Lorsqu'aucun dysfonctionnement du transistor 12 n'est détecté, l'allumeur 22 est apte à générer un signal nominal SN. Le signal de supervision SS correspond alors au signal nominal SN.

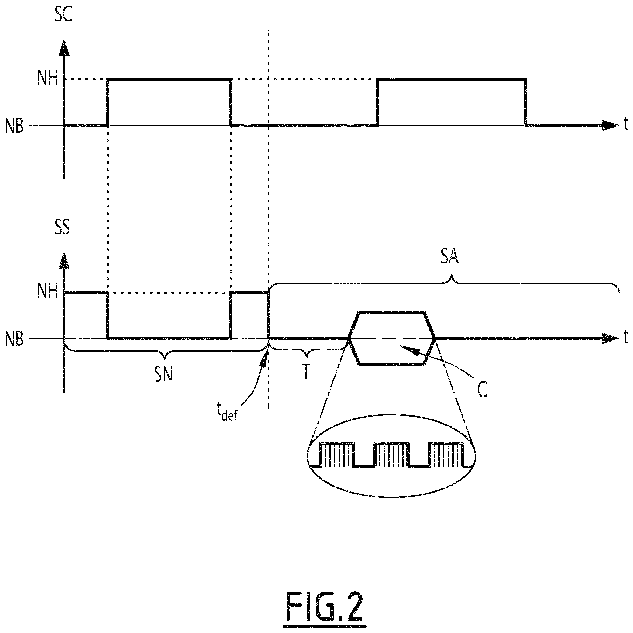

La figure 2 illustre un chronogramme d'un exemple de signal de commande SC (signal de commande SC en fonction du temps t) et un chronogramme d'un exemple de signal de supervision SS (signal de supervision SS en fonction du temps t).

Comme illustré sur la figure 2, le signal de commande SC et le signal de supervision SS sont des signaux sensiblement logiques étant soit à un niveau haut NH soit à un niveau bas NB opposé au niveau haut NH. Par sensiblement logique on entend que le signal de commande SC et le signal de supervision SS sont formés majoritairement de signaux logiques et ponctuellement de signaux analogiques. En particulier, le signal nominal SN et le signal d'alerte SA sont des signaux sensiblement logiques.

Par exemple, lorsque qu'aucun dysfonctionnement n'est détecté et lorsque le signal de commande SC est au niveau haut NH, l'allumeur 22 contrôle le transistor 12 de sorte que celui-ci soit dans l'état passant. Par exemple, lorsqu'aucun dysfonctionnement n'est détecté et lorsque le signal de commande SC est au niveau bas NB, l'allumeur 22 contrôle le transistor 12 de sorte que celui-ci soit dans l'état bloqué.

Le signal nominal SN est un signal logique opposé du signal de commande SC. En d'autres termes, lorsqu'aucun dysfonctionnement du transistor 12 n'est détecté et lorsque le signal de commande SC est au niveau haut NH, le signal de supervision SS, qui correspond alors au signal nominal SN, est au niveau bas NB et inversement.

A partir d'un instant t_{def} de détection d'un dysfonctionnement, le signal de supervision SS devient le signal d'alerte SA.

Comme illustré sur la figure 2, le signal d'alerte SA est un signal constant sur au moins une période de temps T à partir de l'instant t_{def}. A partir de l'instant t_{def} et, au moins pendant la période de temps T, le signal de supervision SS, qui correspond alors au signal d'alerte SA, est au même niveau que le niveau du signal de commande SC à l'instant t_{def} de détection du dysfonctionnement.

Ainsi, selon l'exemple illustré sur la figure 2, à l'instant t_{def}, le signal de commande étant au niveau bas NB, le signal d'alerte SA est donc également au niveau bas à partir de l'instant t_{def} et au moins pendant la période de temps T.

En cas de détection d'un dysfonctionnement, le signal de commande SC et le signal de supervision SS sont donc les deux à un même niveau haut ou bas sur au moins une période de temps T.

En cas de détection d'un dysfonctionnement du transistor 12, l'allumeur 22 est apte, en outre, à générer des données de défaut représentatives dudit dysfonctionnement et à encoder lesdites données de défaut dans le signal d'alerte SA en formant une composante utile C du signal d'alerte SA correspondant. Cette composante utile C est donc intégrée dans le signal d'alerte SA et présente également un signal sensiblement logique. La composante utile C comprend par exemple des suites d'un caractère formant des bits d'information et permettant ainsi d'encoder les données correspondantes.

Les données de défaut sont, en particulier, encodées selon le protocole RS-232.

Les données de défaut comprennent des informations sur le dysfonctionnement détecté. Elles comprennent, par exemple, au moins la nature du dysfonctionnement choisi dans la liste comprenant un non-allumage du transistor 12, une non-saturation du transistor 12, une désaturation du transistor 12, une sous-tension du transistor 12 et une surtension du transistor 12.

L'allumeur 22 est, en particulier, configuré pour encoder les données de défaut dans le signal d'alerte SA après ladite période de temps T. Ce décalage temporel entre l'émission du signal d'alerte SA et l'encodage des données de défaut permet au module de gestion 24 de s'apprêter à la réception desdites données de défaut.

Comme illustré sur la figure 1, en cas de réception d'un signal d'alerte SA, le module de gestion 24 est configuré pour générer un message d'alerte MA à destination du module de supervision 20. En particulier, le module de gestion 24 est configuré pour générer le message d'alerte MA lorsque le signal de commande SC qu'il reçoit depuis le module de supervision 20 et le signal de supervision SS qu'il reçoit depuis l'allumeur 22 sont les deux à un même niveau haut ou bas sur au moins une période de temps T. En d'autre termes, le module de gestion 24 reconnaît la détection d'un dysfonctionnement dès que les signaux de commande SC et de supervision SS sont à un même niveau sur au moins une période de temps T.

En cas de détection d'un dysfonctionnement du transistor 12, le module de gestion 24 est, en outre, apte à extraire les données de défaut en décodant la composante utile C du signal d'alerte SA. Le message d'alerte MA contient alors les informations sur le dysfonctionnement détecté. Ces informations sont, par exemple, destinées à permettre à au module de supervision 20 d'identifier le dysfonctionnement et d'éventuellement le corriger.

En outre, afin de protéger le transistor 12 et/ou l'allumeur 22, en cas de détection d'un dysfonctionnement, le module de gestion 24 est configuré pour générer un signal d'extinction et le transmettre à l'allumeur 22 pour empêcher l'allumeur 22 de contrôler le transistor 12.

Dans ce qui suit on décrit un procédé de contrôle d'un transistor 12 à l'aide d'un dispositif de contrôle 14 tel que décrit précédemment.

Le procédé de contrôle comprend une première étape de génération d'un signal de commande SC. Le signal de commande SC est, par exemple, généré par le module de supervision 20 et est transmis au module de gestion 24 puis à l'allumeur 22.

Le procédé de contrôle comprend, en outre, une étape de contrôle du fonctionnement du transistor 12 à partir du signal de commande SC. Par exemple, l'allumeur 22 contrôle le transistor 12 entre l'état passant et l'état bloqué en générant le signal de contrôle SO et en le transmettant au transistor 12.

L'allumeur 22 génère ensuite un signal de supervision SS dépendant du signal de commande SC et le transmet au module de surveillance 24. Lorsqu'aucun dysfonctionnement n'est détecté, l'allumeur génère un signal nominal SN. Le signal de supervision SS correspond alors au signal nominal SN.

En cas de détection d'un dysfonctionnement du transistor 12, un signal d'alerte SA est généré. Par exemple, l'allumeur 22 génère le signal d'alerte SA. Le signal de supervision SS correspond alors au signal d'alerte SA.

Des données de défaut représentatives dudit dysfonctionnement sont alors générées et encodées dans le signal d'alerte SA en formant une composante utile C du signal d'alerte SA correspondant. Par exemple, l'allumeur 22 génère et encode les données de défaut.

Enfin, le signal d'alerte SA est reçu et les données de défaut sont extraites par décodage de la composante utile C du signal d'alerte SA. Par exemple, le module de gestion 24 reçoit le signal d'alerte et décode la composante utile C. Suite à la réception du signal d'alerte SA, le module de gestion 24 génère un message d'alerte MA à destination du module de supervision 20.

L'allumeur 22, en particulier l'unité de surveillance 32, est apte à générer des données de défaut représentatives du dysfonctionnement de l'unité de contrôle 32 et à encoder lesdites données de défaut dans la composante utile C du signal d'alerte SA.

Grâce à l'invention, lorsqu'un dysfonctionnement survient dans le transistor 12, le module de gestion 24 reconnaît qu'un dysfonctionnement est survenu et reçoit, en outre, une information correspondant, par exemple, à la nature dudit dysfonctionnement par l'intermédiaire d'un unique signal de supervision SS.

Le module de supervision 20 peut alors prendre connaissance dudit dysfonctionnement en recevant le message d'alerte MA. Il peut alors effectuer, si nécessaire, les tâches adéquates pour corriger ce dysfonctionnement et/ou éventuellement communiquer le dysfonctionnement à un opérateur.

## Revendications

1. Dispositif (14) de contrôle d'un transistor (12) comprenant :
- un module de supervision (20) apte à générer un signal de commande (SC) ;
- un allumeur (22) apte à contrôler le fonctionnement du transistor (12) à partir du signal de commande (SC), à détecter un dysfonctionnement du transistor (12) et à générer un signal d'alerte (SA) en cas de détection d'un dysfonctionnement du transistor (12) ;
- un module de gestion (24) apte à recevoir le signal d'alerte (SA) ;
l'allumeur (22) étant apte en outre, en cas de détection d'un dysfonctionnement du transistor (12), à générer des données de défaut représentatives dudit dysfonctionnement et à encoder lesdites données de défaut dans le signal d'alerte (SA) en formant une composante utile (C) du signal d'alerte (SA) correspondant, les données de défaut étant encodées selon le protocole RS-232, le module de gestion (24) étant apte à extraire les données de défaut en décodant la composante utile (C) du signal d'alerte (SA).

2. Dispositif de contrôle (14) selon la revendication 1, dans lequel les données de défaut comprennent au moins la nature du dysfonctionnement choisi dans la liste comprenant un non-allumage du transistor (12), une non-saturation du transistor (12), une désaturation du transistor (12), une sous-tension du transistor (12) et une surtension du transistor (12).

3. Dispositif de contrôle (14) selon l'une quelconque des revendications précédentes, dans lequel le signal de commande (SC) et le signal d'alerte (SA) sont des signaux sensiblement logiques étant soit à un niveau haut (NH) soit à un niveau bas (NB) opposé au niveau haut (NH).

4. Dispositif de contrôle (14) selon la revendication 3, dans lequel lorsqu'aucun dysfonctionnement du transistor (12) n'est détecté, l'allumeur (22) est apte à générer un signal nominal (SN), le signal nominal (SN) étant un signal logique opposé du signal de commande (SC), le module de gestion (24) étant apte, en outre, à recevoir le signal nominal (SN).

5. Dispositif de contrôle (14) selon la revendication 4, dans lequel le signal d'alerte (SA) est un signal constant sur au moins une période de temps (T) à partir d'un instant (t_{def}) de détection du dysfonctionnement, le signal d'alerte (SA) étant au même niveau que le niveau du signal de commande (SC) à l'instant (t_{def}) de détection du dysfonctionnement.

6. Dispositif de contrôle (14) selon la revendication 5, dans lequel l'allumeur (22) est configuré pour encoder les données de défaut dans le signal d'alerte (SA) après ladite période de temps (T).

7. Dispositif de contrôle (14) selon l'une quelconque des revendications précédentes, dans lequel le module de gestion (24) est configuré pour générer un message d'alerte (MA) à destination du module de supervision (20) en cas de réception du signal d'alerte (SA).

8. Dispositif de contrôle (14) selon l'une quelconque des revendications précédentes, dans lequel le module de gestion (24) est configuré en outre pour empêcher l'allumeur (22) de contrôler le transistor (12) en cas de réception du signal d'alerte (SA).

9. Procédé de contrôle d'un transistor (12), comprenant les étapes de :
- génération d'un signal de commande (SC) par un module de supervision (20) ;
- contrôle du fonctionnement du transistor (12) à partir du signal de commande (SC) ;
- génération d'un signal d'alerte (SA) en cas de détection d'un dysfonctionnement du transistor (12) ;
- génération de données de défaut représentatives dudit dysfonctionnement et encodage desdites données de défaut dans le signal d'alerte (SA) en formant une composante utile (C) du signal d'alerte (SA) correspondant, les données de défaut étant encodées selon le protocole RS-232 ;
- réception du signal d'alerte (SA) par un module de gestion (24) et extraction des données de défaut par décodage de la composante utile (C) du signal d'alerte (SA).
